(19) **Europäisches Patentamt** / **European Patent Office** / **Office européen des brevets**

(11) **EP 4 510 457 A1**

(12) **EUROPEAN PATENT APPLICATION**
published in accordance with Art. 153(4) EPC

(43) Date of publication:
**19.02.2025 Bulletin 2025/08**

(21) Application number: **23806676.5**

(22) Date of filing: **19.04.2023**

(51) International Patent Classification (IPC):
**H03M 13/03** (2006.01)

(52) Cooperative Patent Classification (CPC):
**H03M 13/03; H03M 13/11; H03M 13/13; H03M 13/15; H03M 13/23; H03M 13/29**

(86) International application number:
**PCT/CN2023/089282**

(87) International publication number:
**WO 2023/221723 (23.11.2023 Gazette 2023/47)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **19.05.2022 CN 202210545672**

(71) Applicant: **ZTE Corporation**
**Shenzhen, Guangdong 518057 (CN)**

(72) Inventors:
• **LI, Liguang**
  **Shenzhen, Guangdong 518057 (CN)**
• **YUAN, Zhifeng**
  **Shenzhen, Guangdong 518057 (CN)**
• **XU, Jin**
  **Shenzhen, Guangdong 518057 (CN)**
• **LIANG, Chulong**
  **Shenzhen, Guangdong 518057 (CN)**

(74) Representative: **Savi, Massimiliano et al**
**Notarbartolo & Gervasi S.p.A.**
**Viale Achille Papa, 30**
**20149 Milano (IT)**

(54) **DATA PROCESSING METHOD, ELECTRONIC DEVICE, STORAGE MEDIUM, AND PROGRAM PRODUCT**

(57) The present application discloses a data processing method, an electronic device, a storage medium, and a program product. The data processing method comprises: performing error correction coding on an obtained information bit sequence to obtain a first coded bit sequence of a target length; repeatedly expanding the first coded bit sequence to obtain a second coded bit sequence; and sending the second coded bit sequence to a receiving end.

```
┌──────────────────────────────────────────────────┐
│ Perform error correction coding on an acquired     │ ── S110
│ information bit sequence to obtain a first coded    │
│ bit sequence having a target length                 │
└──────────────────────────────────────────────────┘
                        │
                        ▼
┌──────────────────────────────────────────────────┐
│ Repeatedly expand the first coded bit sequence to  │ ── S120
│ obtain a second coded bit sequence                  │
└──────────────────────────────────────────────────┘
                        │
                        ▼
┌──────────────────────────────────────────────────┐
│ Send the second coded bit sequence to a receiving  │ ── S130
│ end                                                 │
└──────────────────────────────────────────────────┘
```

FIG. 4

EP 4 510 457 A1

**Description**

**CROSS-REFERENCE TO RELATED APPLICATION**

This application is filed on the basis of Chinese patent application No. 202210545672.5 filed May 19, 2022, and claims priority to the Chinese patent application, the entire contents of which are incorporated herein by reference.

**TECHNICAL FIELD**

The present disclosure relates to the technical field of communication, and more particularly, to a data processing method, an electronic device, a computer storage medium, and a computer program product.

**BACKGROUND**

In a digital communication system, the transmitting end performs channel coding on an original information bit sequence to acquire a coded bit sequence. This coded bit sequence is then mapped to constellation modulation symbols, which are ultimately transmitted. During transmission through the channel, the data may become distorted due to factors such as multipath propagation, movement, noise, and interference. Channel coding, for instance, may involve Forward Error Correction (FEC) coding. Currently, in conventional coding schemes, to reduce the performance loss caused by sudden interference, modules such as sub-block interleaving, bit collection, and bit selection are added. While these coding schemes improve the resistance to sudden fading and interference in the channel, they increase the hardware complexity, fail to ensure the simplified implementation and transmission reliability for tap devices of passive Internet of Things (IoT), and consume more power.

**SUMMARY**

Embodiments of the present disclosure provide a data processing method, an electronic device, a computer storage medium, and a computer program product, to ensure the simplified implementation and data transmission reliability of tap devices and reduce the power consumption.

In accordance with a first aspect of the present disclosure, an embodiment provides a data processing method, including:

performing error correction coding on an acquired information bit sequence to obtain a first coded bit sequence having a target length;

repeatedly expanding the first coded bit sequence to obtain a second coded bit sequence; and

sending the second coded bit sequence to a receiving end,

where repeatedly expanding the first coded bit sequence to obtain a second coded bit sequence includes:

for each first bit in the first coded bit sequence, repeatedly generating another first bit until a preset target number of times is reached, to obtain a bit sequence including a plurality of first bits, and generating the second coded bit sequence sequentially according to the respective bit sequences; or

repeatedly generating another first coded bit sequence having the target length until a preset target number of times is reached, to obtain a plurality of first coded bit sequences, and generating the second coded bit sequence sequentially according to the plurality of first coded bit sequences.

In accordance with a second aspect of the present disclosure, an embodiment provides a data processing method, including:

receiving a second coded bit sequence sent by a transmitting end; and

processing the second coded bit sequence,

where the second coded bit sequence is obtained by the transmitting end by performing a first operation or a second operation on a first coded bit sequence having a target length, and the first coded bit sequence is obtained by the transmitting end by performing error correction coding on an acquired information bit sequence;

the first operation includes: for each first bit in the first coded bit sequence, repeatedly generating another first bit until a preset target number of times is reached, to obtain a bit sequence including a plurality of first bits, and generating the second coded bit sequence sequentially according to the respective bit sequences; and

the second operation includes: repeatedly generating another first coded bit sequence having the target length until a preset target number of times is reached, to obtain a plurality of first coded bit sequences, and generating the second coded bit sequence sequentially according to the plurality of first coded bit sequences.

In accordance with a third aspect of the present disclosure, an embodiment of the present disclosure provides an electronic device, including: at least one processor; and at least one memory, configured for storing at least one program, where the at least one program, when executed by the at least one processor, causes the at least one processor to perform the data processing method described above.

In accordance with a fourth aspect of the present disclosure, an embodiment provides a computer-readable storage medium, storing a processor-executable program which, when executed by a processor, causes the processor to perform the data processing method described above.

In accordance with a fifth aspect of the present disclosure, an embodiment provides a computer program product, including a computer-readable storage medium storing a computer program or computer instructions which, when read and executed by a processor of a computer device, causes the computer device to perform the data processing method described above.

In the embodiments of the present disclosure, error correction coding is performed on an acquired information bit sequence to obtain a first coded bit sequence, the obtained first coded bit sequence is repeatedly expanded to obtain a second coded bit sequence, and the second coded bit sequence is sent to a receiving end serving as a tap device. Because the required second coded bit sequence can be obtained by repeatedly expanding each bit in the first coded bit sequence having a target length or the entire first coded bit sequence for a preset target number of times, the receiving end can easily and conveniently receive and process the second coded bit sequence. The entire processing process is simple and convenient to implement and does not have high hardware requirements. That is to say, the simplified implementation and data transmission reliability of the tap device can be ensured. In addition, the power consumption can be reduced. Therefore, the present disclosure can fill in the technical gap in related methods.

## BRIEF DESCRIPTION OF DRAWINGS

FIG. 1 is a schematic diagram of an implementation environment configured for executing a data processing method according to an embodiment of the present disclosure;

FIG. 2 is a schematic diagram of an implementation environment configured for executing a data processing method according to another embodiment of the present disclosure;

FIG. 3 is a schematic diagram of an IoT device using FEC coding in an implementation environment configured for executing a data processing method according to an embodiment of the present disclosure;

FIG. 4 is a flowchart of a data processing method according to an embodiment of the present disclosure;

FIG. 5 is a flowchart of performing error correction coding on an acquired information bit sequence to obtain a first coded bit sequence having a target length in a data processing method according to an embodiment of the present disclosure;

FIG. 6 is a schematic diagram of a data processing method based on IoT communication according to an embodiment of the present disclosure;

FIG. 7 is a schematic diagram of a data processing method based on IoT communication according to another embodiment of the present disclosure;

FIG. 8 is a schematic diagram of a data processing method based on IoT communication according to another embodiment of the present disclosure;

FIG. 9 is a flowchart of sending the second coded bit sequence to a receiving end in the data processing method according to an embodiment of the present disclosure;

FIG. 10 is a schematic diagram of data sending using the backscattering principle based on IoT communication according to an embodiment of the present disclosure;

FIG. 11 is a schematic diagram showing a comparison of performance of the second coded bit sequence corresponding to different preset numbers of times according to an embodiment of the present disclosure;

FIG. 12 is a flowchart of a data processing method according to another embodiment of the present disclosure;

FIG. 13 is a flowchart of processing the second coded bit sequence in the data processing method according to an embodiment of the present disclosure; and

FIG. 14 is a flowchart of performing de-duplication processing on the second coded bit sequence to obtain the first coded bit sequence in the data processing method according to an embodiment of the present disclosure;

FIG. 15 is a flowchart of performing convolutional decoding on the first coded bit sequence to obtain the information bit sequence in the data processing method according to an embodiment of the present disclosure; and

FIG. 16 is a schematic diagram of an electronic device according to an embodiment of the present disclosure.

## DETAILED DESCRIPTION

To make the purposes, technical schemes, and advantages of the present disclosure clear, it is described in further detail in conjunction with accompanying drawings and examples. It should be understood that the specific embodiments described herein are merely used for illustrative purposes, and are not intended to limit the scope of the present disclosure.

It is to be noted, although logical orders have been shown in the flowcharts, in some cases, the steps shown or described may be executed in an order different from the orders as shown in the flowcharts. The terms such as "first", "second" and the like in the description, the claims, and the accompanying drawings are used merely to distinguish between similar elements and are not intended to denote a specific sequence or priority.

The present disclosure provides a data processing method, an electronic device, a computer storage medium, and a computer program product. In an embodiment, the data processing method includes: performing error correction coding on an acquired information bit sequence to obtain a first coded bit sequence having a target length; repeatedly expanding the first coded bit sequence to obtain a second coded bit sequence; and sending the second coded bit sequence to a receiving end, where repeatedly expanding the first coded bit sequence to obtain a second coded bit sequence includes: for each first bit in the first coded bit sequence, repeatedly generating another first bit until a preset target number of times is reached, to obtain a bit sequence including a plurality of first bits, and generating the second coded bit sequence sequentially according to the respective bit sequences; or repeatedly generating another first coded bit sequence having the target length until a preset target number of times is reached, to obtain a plurality of first coded bit sequences, and generating the second coded bit sequence sequentially according to the plurality of first coded bit sequences. In this embodiment, error correction coding is performed on an acquired information bit sequence to obtain a first coded bit sequence, the obtained first coded bit sequence is repeatedly expanded to obtain a second coded bit sequence, and the second coded bit sequence is sent to a receiving end serving as a tap device. Because the required second coded bit sequence can be obtained by repeatedly expanding each bit in the first coded bit sequence having a target length or the entire first coded bit sequence by a preset target number of times, the receiving end can easily and conveniently receive and process the second coded bit sequence. The entire processing process is simple and convenient to implement and does not have high hardware requirements. That is to say, the simplified implementation and data transmission reliability of the tap device can be ensured. In addition, the power consumption can be reduced. Therefore, the present disclosure can fill in the technical gap in related methods.

The embodiments of the present disclosure will be further described in detail below in conjunction with the accompanying drawings.

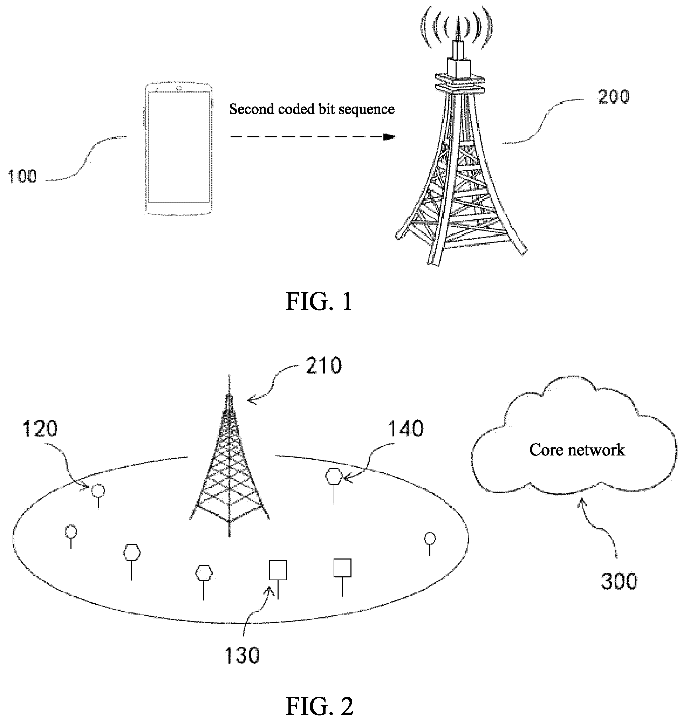

FIG. 1 is a schematic diagram of an implementation environment configured for executing a data processing method according to an embodiment of the present disclosure.

In the example of FIG. 1, the implementation environment includes, but not limited to, a transmitting end 100 and a receiving end 200. The receiving end 200 and the transmitting end 100 can send wireless signals to each other, receive wireless signals from each other, perform related interaction with each other, and so on.

In an embodiment, the relative positions, numbers, etc., of the receiving end 200 and the transmitting end 100 may be set according to specific application scenarios. If there are a plurality of receiving ends 200 and different receiving ends 200 are arranged in the above manner, the wireless signal sent by the transmitting end 100 can be received at different spatial positions. It should be noted that the spatial positions may be different geographical locations.

In an implementation, the transmitting end 100 and the receiving end 200 each may include, but not limited to, one of the following devices: a Base Station (BS), an Access Point (AP), a NodeB, a generalized Node B (g NodeB), a Radio Network Controller (RNC), an Evolved NodeB (eNB), a Base Station Controller (BSC), a Base Transceiver Station (BTS), a Transceiver Function (TF), a radio router, a radio transceiver, a Basic Service Set (BSS), an Extended Service Set (ESS), or a Radio Base Station (RBS), which is not particularly limited in this embodiment.

In an implementation, the transmitting end 100 and the receiving end 200 may each be referred to as an access terminal device, a User Equipment (UE), a subscriber unit, a subscriber station, a mobile station, a remote station, a remote terminal device, a mobile device, a user terminal device, a wireless communication device, a user agent, or a user device. For example, the transmitting end 100 may be a cellular phone, a cordless telephone, a Session Initiation Protocol (SIP) telephone, a Wireless Local Loop (WLL) station, a Personal Digital Assistant (PDA), a handheld device with a wireless communication function, a computing device or other processing device connected to a wireless modem, a vehicle-mounted device, a wearable device, a terminal device in a 5G network or future evolved networks, etc., which is not limited in this embodiment.

In an implementation, the implementation environment configured for executing the data processing method in this embodiment may be, but not limited to, some networks that can automatically adapt to wireless communication device, e.g., an IoT. The transmitting end 100 and the receiving end 200 may be devices that communicate through the IoT (e.g., Machine Type Communication devices) and may include, but not limited to, various types of sensors, water meters, electricity meters, commodity labels, article data labels, etc.

In some scenarios, devices in the IoT have a low battery capacity. Such devices may have applications with very low throughput and data volume but requiring very little power consumption in order to communicate for a very long time without replacing the battery. Alternatively, a device in the IoT does not require the use of a battery for storing power, but directly transmits a signal to the receiving end 200 (e.g., base station) by backscattering. When a device in the IoT such as a tap device collects power and backscatters a signal to the receiving end 200, the device may be a passive IoT device, which may be used in a licensed spectrum, e.g., to send a signal to a mobile communication base station (e.g., NodeB or G NodeB) or access an existing cellular mobile network.

In some scenarios, the IoT device may also communicate using an unlicensed spectrum.

In some scenarios, the IoT device uses an impedance network to send data, where different impedance network parameters are used to indicate different data signals.

In some scenarios, the IoT device may perform FEC coding on the data to be sent to improve the reliability of data transmission. For example, performing FEC coding on the original data to be sent can increase the coverage range or reduce the power consumption of transmission. The FEC coding may be, but not limited to, Hamming coding, polar coding, Low Density Parity Check Code (LDPC) coding, Reed-Solomon (RS) coding, convolutional coding, turbo coding, etc.

FIG. 2 is a schematic diagram of an implementation environment configured for executing a data processing method according to another embodiment of the present disclosure.

In FIG. 2, the implementation environment includes a base station 210 (i.e., a receiving end 200), various types of UEs (including UEs 120, 130, and 140 in FIG. 2, i.e., the transmitting end 100), and a core network 300. The UEs may each be an IoT device, which is configured for collecting various information, then performing FEC coding on the data information, and sending the coded data information to the base station 210. The base station 210 communicates with the UEs and is connected to the core network 300. The core network 300 may provide functions such as access authorization, user authentication, Internet Protocol (IP) connectivity, tracing and other access, routing or mobility management. The UEs may be scattered in the entire implementation environment, and each UE may be fixed or mobile. The UEs may communicate with various types of base stations 210 and network devices (including macro eNBs, small cell eNBs, relay base stations, and the like).

It can be understood that examples of applications for IoT devices include, but not limited to, intelligent metering, inventory monitoring, water level monitoring, temperature monitoring, device monitoring, medical monitoring, wildlife monitoring, weather and geographic event monitoring, fleet management and tracking, remote security awareness, physical access control, and transaction-based business charges, etc.

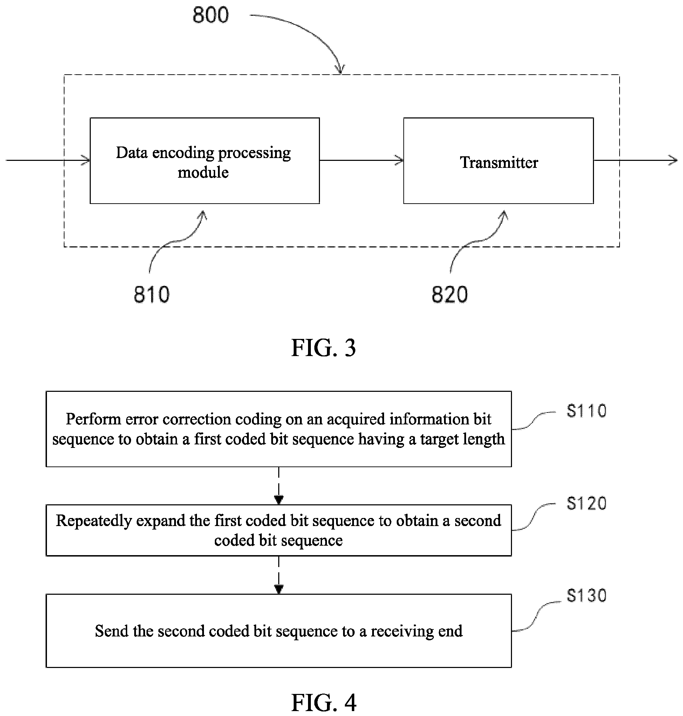

FIG. 3 is a schematic diagram of an IoT device 800 using FEC coding in the implementation environment. The IoT Device 800 may include, but not limited to, a data encoding processing module 810 and a transmitter 820. In addition, the IoT device may also include a processor, a memory, etc., for performing processing operations on data, such as storing some necessary parameter data and an information bit sequence, performing FEC coding processing on the input information bit sequence, sending the encoded data in sequence, and so on. The components in the IoT device 800 may communicate with each other. The transmitter 820 may include a single antenna or multiple antennas.

The transmitting end 100 has at least functions of performing error correction coding on the information bit sequence to obtain a first coded bit sequence, repeatedly expanding the first coded bit sequence to obtain a second coded bit sequence, sending the second coded bit sequence to the receiving end 200, and so on.

The receiving end 200 has at least functions of receiving the second coded bit sequence sent by the transmitting end 100, processing the second coded bit sequence, and so on. The second coded bit sequence is obtained by the transmitting end 100 by repeatedly expanding the first coded bit sequence, and the first coded bit sequence is obtained by the transmitting end 100 by performing error correction coding on the acquired information bit sequence.

In an embodiment, the above functions of the transmitting end 100 and the receiving end 200 may be applied to different application scenarios, which is not limited herein.

It can be understood by those having ordinary skills in the art that the implementation environment may be applied to 5G and 6G communication network systems, future evolved mobile communication network systems, etc., which is not particularly limited in this embodiment.

Those having ordinary skills in the art may understand that the implementation environments shown in FIG. 1, FIG. 2, and FIG. 3 do not constitute a limitation to the implementation embodiments of the present disclosure, and more or fewer components than those shown in the figure may be included, or some components may be combined, or a different component arrangement may be used.

Based on the above implementation environment, various embodiments of the data processing method of the present disclosure are proposed below.

FIG. 4 is a flowchart of a data processing method according to an embodiment of the present disclosure. The data processing method may include, but not limited to, the following steps S110 to S130.

At S110, error correction coding is performed on an acquired information bit sequence to obtain a first coded bit sequence having a target length.

In an embodiment, the execution entity of the data processing method in this embodiment may be, but not limited to, the transmitting end 100 in the embodiment shown in FIG. 1, or the UE in the embodiment shown in FIG. 2, or the IoT device 400 in the embodiment shown in FIG. 3, or those having ordinary skills in the art may set the corresponding execution entity according to actual application scenarios, which is not limited in this embodiment. To more conveniently describe the application scenarios and principles of the present disclosure, the following related embodiments are described with the transmitting end as the execution entity of the data processing method, which should not be construed as a limitation to the embodiments of the present disclosure.

In this step, the first coded bit sequence is obtained by performing error correction coding on the acquired information bit sequence, such that a new coded bit sequence can be obtained by further processing the first coded bit sequence in subsequent steps.

In an embodiment, the information bit sequence may be acquired by a variety of methods, which may be selected by those having ordinary skills in the art according to actual application scenarios , which is not particularly limited herein.

In an embodiment, the error correction coding includes at least one of:

LDPC coding;

polar coding;

RS coding;

tail-biting convolutional coding;

turbo coding; or

Bose-Chaudhuri-Hocquenghem (BCH) coding.

An LDPC code is determined by a low-density parity check matrix, and the information bit sequence is encoded according to the parity check matrix to obtain an LDPC coded bit sequence. In an example, the parity check matrix for the LDPC code may be determined by one or more fundamental matrices. Dimensions of each of the fundamental matrices include 42 rows by 52 columns or 46 rows by 68 columns. Each of the fundamental matrices includes elements indicating an all-zero matrix and elements indicating a cyclic shift of a unit matrix.

A polar code is a linear block code proposed based on the channel polarization theory. In an example, the polar code is defined by an n-order Kronecker product of a matrix G, where the matrix G is a matrix of 2 rows by 2 columns. In an example, G= [1 0; 1 1].

The RS coding is a coding method that can maximize the minimum distance, and therefore has a very strong capability of correcting burst errors. In an example, an RS code with a code length $n1$ and an information length $k1$ is defined by a generator polynomial, and any codeword polynomial output from the RS code is divisible by the generator polynomial. In an example, n1 is equal to 2 to the power m minus 1, where m is equal to one of 4, 5, 6, 7, 8, 9, or 10.

BCH codes form a class of cyclic codes that can correct a plurality of random errors, and are binary linear cyclic codes invented independently by Bose, Chaudhuri and Hocquenghem, named by the initials of their names. In an example, the BCH codes are determined by a generator polynomial, which is determined by a plurality of primitive polynomials.

A turbo code is a parallel concatenation of convolutional codes, i.e., includes two or more component codes concatenated in parallel. The output of the turbo code may be a systematic code. In an embodiment, turbo is a turbo coding method defined in a Long Term Evolution (LTE) system, which includes two component codes and system bits, with a mother code rate of 1/3. An LDPC code is determined by a low-density parity check matrix, and the information bit sequence is encoded according to the parity check matrix to obtain an LDPC coded bit sequence. A polar code is a linear block code proposed based on the channel polarization theory. When polar coding is used, a coded bit sequence of S bits may be output for every 1 bit input, where S is a positive integer.

When tail-biting convolutional coding is performed on the acquired information bit sequence, that is, an initial state and a final state of a code trellis of convolutional coding are the same, the decoding performance of the tail-biting convolutional coding can be improved. For example, v-1 bits in the tail of the information bit sequence may be sequentially stored in a convolutional coding register, and then all bits of the information bit sequence are sequentially shifted into the register bit by bit and coded to obtain the first coded bit sequence.

It can be understood that the specific error correction coding method may also be set according to specific application scenarios, which is not limited in this embodiment.

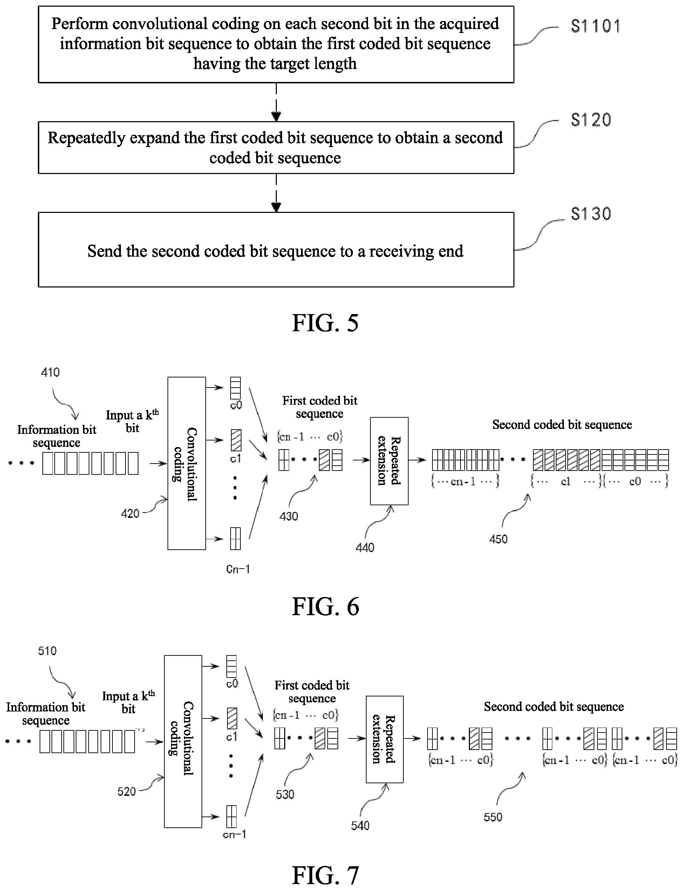

As shown in FIG. 5, in an embodiment of the present disclosure, S110 is further described, and S110 may include, but not limited to, a following step S1101.

At S1101, convolutional coding is performed on each second bit in the acquired information bit sequence to obtain the first coded bit sequence having the target length.

In this step, each bit is sequentially selected from the acquired information bit sequence and convolutional-coded, to obtain the first coded bit sequence having the target length. That is to say, by this method, each bit in the information bit sequence can be respectively convolutional-coded to obtain a first coded bit sequence having the target length corresponding to each bit, such that the required first coded bit sequences can be further processed in subsequent steps. For example, by convolutional-coding a $k^{th}$ bit in the information bit sequence, a first coded bit sequence $\{c_0, c_1, c_2, ..., c_{n-1}\}$ having a target length of n bits can be obtained, where k=0, 1, 2, ..., n-1.

At S120, the first coded bit sequence is repeatedly expanded to obtain a second coded bit sequence.

In an embodiment, repeatedly expanding the first coded bit sequence to obtain a second coded bit sequence includes:

for each first bit in the first coded bit sequence, repeatedly generating another first bit until a preset target number of times is reached, to obtain a bit sequence including a plurality of first bits, and generating the second coded bit sequence sequentially according to the bit sequences; or

repeatedly generating another first coded bit sequence having the target length until a preset target number of times is reached, to obtain a plurality of first coded bit sequences, and generating the second coded bit sequence sequentially according to the plurality of first coded bit sequences.

In this step, the first coded bit sequence is repeatedly expanded. That is to say, the original first coded bit sequence is expanded to obtain the second coded bit sequence, and the obtained second coded bit sequence can meet a coding requirement. For example, when the first coded bit sequence $\{c_0, c_1, c_2, ..., c_{n-1}\}$ having the length of n bits is obtained by performing error correction coding on the $k^{th}$ bit in the information bit sequence, the first coded bit sequence is repeatedly expanded for a preset number q of times to obtain a second coded bit sequence having a length of n×q bits. By repeatedly expanding each first bit in the first coded bit sequence or repeatedly expanding the first coded bit sequence as a whole, repetitive coding can be achieved without consuming too much power. That is to say, through the repeated expansion described above, it is not necessary to perform sub-block interleaving, bit collection, bit selection, and other steps as in conventional convolutional coding, and repetitive coding can be achieved more conveniently through bit expansion or bit sequence expansion. For example, each bit of the first coded bit sequence $\{c_0, c_1, c_2, ..., c_{n-1}\}$ is separately repeatedly expanded for q times to obtain a second coded bit sequence having a length of n×q bits $\{[c_0, c_0, ..., c_0], [c_1, c_1, ..., c_1], ..., [c_{n-1}, c_{n-1}, ..., c_{n-1}]\}$, or the entire first coded bit sequence $\{c_0, c_1, c_2, ..., c_{n-1}\}$ is repeatedly expanded for q times to obtain a second coded bit sequence having a length of n×q bits: $\{[c_0, c_1, c_2, ..., c_{n-1}], [c_0, c_1, c_2, ..., c_{n-1}], ..., [c_0, c_1, c_2, ..., c_{n-1}]\}$.

In an embodiment, the target length is determined by at least one of:

the preset target number of times;

a predetermined number of target impedance networks;

a constraint length of the error correction coding;

a length of the information bit sequence; or

high-layer configuration signaling.

In an implementation, the target length n includes at least one of: 2, 3, 4, 5, 6, 7, 8, 9, 10, 11, or 12.

In an implementation, a constraint length v of the convolutional coding includes at least one of: 7, 8, 9, 10, 11.

In an implementation, the number of target impedance networks includes at least one of: 2, 4, 8, 16, or 32.

Examples are given below to illustrate the principles and procedures of the foregoing embodiments.

Example One

Referring to FIG. 6 and FIG. 7, FIG. 6 is a schematic diagram of a data processing method based on convolutional coding in IoT communication in this embodiment, and FIG. 7 is a schematic diagram of another data processing method based on convolutional coding in IoT communication in this embodiment.

As shown in FIG. 6, convolutional coding 420 is performed on a $k^{th}$ bit of the information bit sequence 410 to output n bits. The output n bits constitute a coded bit sequence 430, such as {c0, c1, c2, ..., cn-1}. Then, a repeated expansion operation 440 is performed on the coded bit sequence 430 to obtain a second coded bit sequence 450, e.g., {[c0, c0, ..., c0], [c1, c1, ..., c1], ..., [cn-1, cn-1, ..., cn-1]}. In an embodiment, a corresponding repeated expansion quantity q (i.e., the preset target number of times) in the repeated expansion operation 440 is equal to 6. The advantages of performing the repeated expansion operation in this manner are as follows. The transmitting end can directly, continuously, and repeatedly send the coded bits output by convolutional coding, which is very simple and efficient, and the hardware implementation can be simplified as much as possible. Moreover, each time the receiving end receives successive q pieces of data information, the receiving end can calculate original information data of the corresponding first bits in the first coded bit sequence, and no caching is required. As such, the hardware complexity is reduced, and the implementation is simplified.

As shown in FIG. 7, convolutional coding 520 is performed on a $k^{th}$ bit of the information bit sequence 510 to output n bits. The output n bits constitute a coded bit sequence 530, such as {c0, c1, c2, ..., cn-1}. Then, a repeated expansion operation 540 is performed on the coded bit sequence 530 to obtain a second coded bit sequence 550, e.g., {[c0, c1, c2, ..., cn-1], [c0, c1, c2, ..., cn-1], ..., [c0, c1, c2, ..., cn-1]}. The advantages of performing the repeated expansion operation in this manner are as follows. The transmitting end continuously sends the coded bit sequence. Because the occurrence probability of '0' is basically equal to that of '1' in the first coded bit sequence, the randomness of the sent signal can be enhanced, the signal coverage can be enlarged, and the hardware complexity can be reduced. In an embodiment, a corresponding repeated expansion quantity q (i.e., the preset target number of times) in the repeated expansion operation 540 is equal to 6.

When the specific value of q is configured through higher-layer signaling, i.e., after the preset target number q of times is determined, the specific value of the number n of component codes in the convolutional coding 420 in FIG. 6 or the convolutional coding 520 in FIG. 7 can be determined according to q.

In an embodiment, the steps of the method shown in FIG. 6 or FIG. 7 may be performed by the data encoding processing module 810 described in FIG. 3. An IoT device (or UE) may execute a set of codes to control functional elements of the IoT device (or UE) to perform corresponding data processing functions.

In an implementation, the preset target number of times is determined by at least one of:

the target length;

a predetermined number of target impedance networks;

a constraint length of the error correction coding;

a length of the information bit sequence; or

high-layer configuration signaling.

The preset target number of times may include, but not limited to, at least one of: 4, 5, 6, 7, 8, 12, 16, 24, 32, 48, or 64. In the IoT device (or UE), the generated second coded bit sequence may be repeatedly sent, such that the robustness of receiving data at the receiving end can be enhanced. The preset target number of times is selected from two or more integers, such that the freedom of scheduling the IoT device (or UE) can be increased. For example, if radio resources in the current scenario are limited, a small preset target number of times may be used. However, in scenarios with high interference, a large preset target number of times may be used to improve the reliability and flexibility of data transmission.

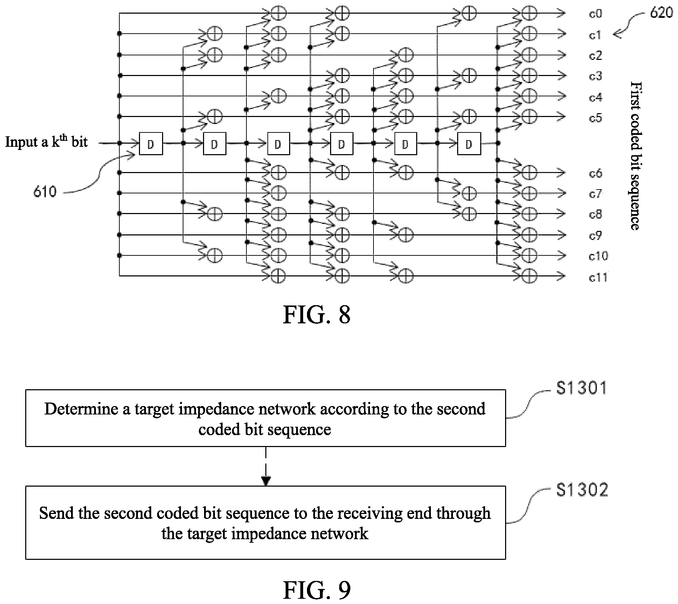

The target length n is equal to the number of component codes in the convolutional coding. FIG. 8 is a schematic diagram of a data processing method using convolutional coding in IoT communication. As shown in FIG. 8, the constraint length v of the convolutional coding is equal to 7, and the number of corresponding shift registers is equal to the constraint length minus 1, so six shift registers 610 are included in FIG. 8. In some examples, the constraint length v of the convolutional coding may be equal to other values, for example, but not limited to, 8, 9, 10, or 11. In the example in FIG. 8, the target length n is equal to 12 (the number of component codes in the convolutional coding is 12, i.e., the convolutional coding has 12 coded outputs), i.e., a first coded bit sequence 620 is {c0, c1, c2, c3, c4, c5, c6, c7, c8, c9, c10, c11}, each bit being obtained through encoding using a generator polynomial. For example, Table 1 below is an example table of generator polynomials for all bits in the first coded bit sequence corresponding to the constraint length of 7 in the convolutional coding, where c0 is generated using a generator polynomial G0 and corresponds to an octet representation of G0=133 and a binary representation of 001 101 101, and c1 is generated using a generator polynomial G1 and corresponds to an octet representation of G1=171 and a binary representation of 001 111 001.

Table 1 Example table of generator polynomials for all bits in the first coded bit sequence corresponding to the constraint length of 7 in the convolutional coding

| c0 | c1 | c2 | c3 | c4 | c5 | c6 | c7 | c8 | c9 | c10 | c11 |
|-----|-----|-----|-----|-----|-----|-----|-----|-----|-----|------|------|
| G0 | G1 | G2 | G3 | G4 | G5 | G6 | G7 | G8 | G9 | G10 | G11 |
| 133 | 171 | 165 | 117 | 135 | 157 | 135 | 123 | 173 | 135 | 171 | 135 |

In an implementation, when the constraint length of the corresponding convolutional coding is v=9, the output coded bit sequence includes 12 bits, i.e., the number of component codes in the convolutional coding is equal to 12. Table 2 is an example table of generator polynomials for all bits in the first coded bit sequence corresponding to the constraint length of 9 in the convolutional coding.

Table 2 Example table of generator polynomials for all bits in the first coded bit sequence corresponding to the constraint length of 9 in the convolutional coding

| c0 | c1 | c2 | c3 | c4 | c5 | c6 | c7 | c8 | c9 | c10 | c11 |
|-----|-----|-----|-----|-----|-----|-----|-----|-----|-----|------|------|
| G0 | G1 | G2 | G3 | G4 | G5 | G6 | G7 | G8 | G9 | G10 | G11 |
| 561 | 753 | 715 | 517 | 675 | 513 | 657 | 745 | 753 | 473 | 745 | 753 |

In another implementation, when the first coded bit sequence includes 2 bits and the corresponding constraint length of the convolutional coding is 7, corresponding generator polynomials are G0 and G1 in Table 1, and the output coded bit sequence is {c0, c1}. Alternatively, when the coded bit sequence includes only 6 bits and the corresponding constraint length of the convolutional coding is 7, corresponding generator polynomials are G0 to G5 in Table 1, and the output coded bit sequence is {c0, c1, c2, c3, c4, c5}. A longer length of the coded bit sequence indicates a lower code rate in the convolutional coding and a better coding gain. Therefore, in the case of sending the same power, a lower code rate helps enlarge the signal coverage of the IoT device. On the contrary, a shorter target length (i.e., a higher code rate) indicates a smaller number of component codes in the convolutional coding, a lower complexity of convolutional coding and decoding, and a simpler implementation of the IoT device.

In another implementation, when the constraint length of the convolutional coding is 7, corresponding generator polynomials include at least two generator polynomials in Table 1, i.e., include at least two of: 133, 171, 165, 117, 135, 157, 123, and 173. In an example, when the constraint length of the convolutional coding is 9, corresponding generator polynomials include at least two generator polynomials in Table 2, i.e., include at least two of: 561, 753, 715, 517, 675, 513, 657, 745, and 473.

In another implementation, when the constraint length of the convolutional coding is 7 and the number of component codes in the convolutional coding is 6, corresponding generator polynomials are G0-G5 in Table 1, namely, 133, 171, 165, 117, 135, and 157, and the corresponding output coded bit sequence is {c0, c1, c2, c3, c4, c5}. In an example, when the constraint length of the convolutional coding is 9 and the number of component codes in the convolutional coding is 6, corresponding generator polynomials are G0-G5 in Table 2, namely, 561, 753, 715, 517, 675, and 513, and the corresponding output coded bit sequence is {c0, c1, c2, c3, c4, c5}. When the number of component codes in the convolutional coding is 6 and the corresponding code rate is 1/6, a maximum coding gain of the convolutional coding is achieved. When the transmission code rate (i.e., a ratio of the length of the information bit sequence to the length of the second coded bit sequence) is less than 1/6, the first coded bit sequence is repeated. Compared with convolutional coding using a larger number of component codes (e.g., greater than 6), convolutional coding repetition using six component codes to achieve a lower transmission code rate (less than 1/6) can reduce the decoding complexity without loss of decoding performance.

In an embodiment, the number of states of the code trellis is determined by the constraint length of the convolutional coding, and the number of states of the code trellis of the convolutional coding is equal to 2 to the power of v-1, where v represents the constraint length of the convolutional coding. For Viterbi decoding of the convolutional coding, a large number of states indicates a higher decoding complexity, and a larger number of path metrics needing to be cached and a larger number of survivor paths indicates a larger number of metric calculations and a higher decoding complexity. However, a longer constraint length indicates a larger minimum code distance of the convolutional coding and therefore better convolutional coding performance. In an example, the constraint length of the convolutional coding may also include at least one of 8, 10, or 11.

At S130, the second coded bit sequence is sent to a receiving end.

In this step, error correction coding is performed on an acquired information bit sequence to obtain a first coded bit sequence, the obtained first coded bit sequence is repeatedly expanded to obtain a second coded bit sequence, and the second coded bit sequence is sent to a receiving end serving as a tap device. Because the required second coded bit sequence can be obtained by repeatedly expanding each bit in the first coded bit sequence having a target length or the entire first coded bit sequence for a preset target number of times, the receiving end can easily and conveniently receive and process the second coded bit sequence. The entire processing process is simple and convenient to implement and does not have high hardware requirements. That is to say, the simplified implementation and data transmission reliability of the tap device can be ensured. In addition, the power consumption can be reduced. Therefore, the present disclosure can fill in the technical gap in related methods.

As shown in FIG. 9, in an embodiment of the present disclosure, S130 is further described, and S130 may include, but not limited to, the following steps S1301 to S1302.

At S1301, a target impedance network is determined according to the second coded bit sequence.

At S1302, the second coded bit sequence is sent to the receiving end through the target impedance network.

In this step, the related target impedance network is determined according to the second coded bit sequence, such that the second coded bit sequence can be sent to the receiving end based on the target impedance network. Multiple circuit tuning frequencies can be realized by adjusting a capacitance parameter of the impedance network, such that the frequency of the sent signal varies with a circuit capacitance value, thereby realizing signal modulation such as frequency shift keying. Therefore, by using the target impedance network meeting the requirements to send the second coded bit sequence to the receiving end, a better signal transmitting effect can be achieved.

In an embodiment, a number of target impedance networks is determined by at least one of:

the target length;

the preset target number of times;

a constraint length of the error correction coding;

a length of the information bit sequence; or

high-layer configuration signaling.

Specific examples are given below to illustrate the principles and procedures of the foregoing embodiments.

Example Two

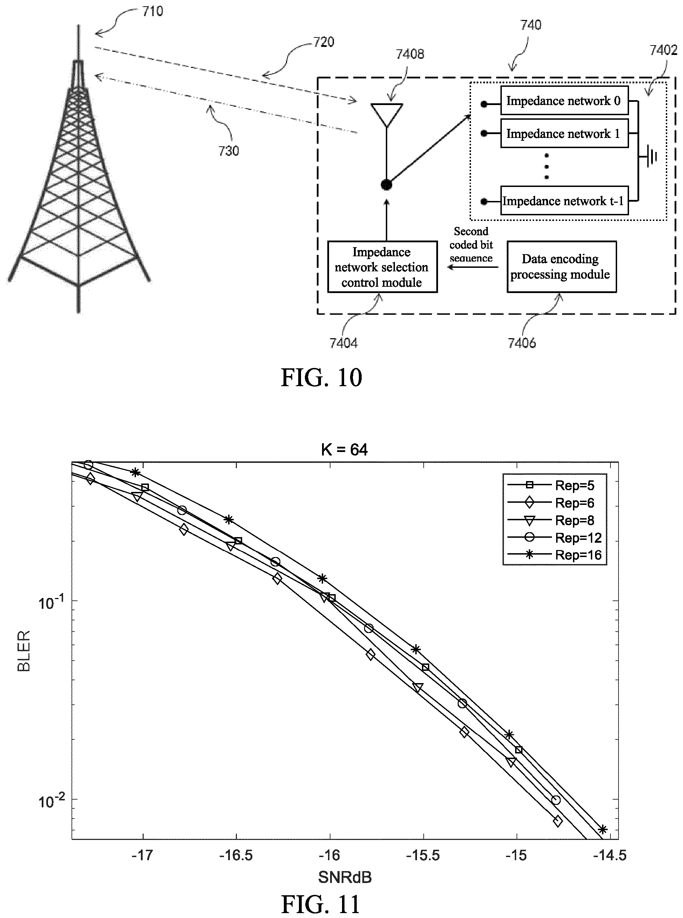

FIG. 10 is a schematic diagram of data sending using the backscattering principle in IoT communication. In FIG. 10, an IoT device 740 receives a carrier signal 720 sent from a base station 710, performs energy collection or signal data reception, and sends an electromagnetic wave signal 730 to the base station 710. The IoT device 740 includes impedance networks 7402, an impedance network selection control module 7404, a data encoding processing module 7406, and a transmit antenna 7408. The impedance networks 7402, the impedance network selection control module 7404, and the transmit antenna 7408 in FIG. 10 may constitute a transmitter 420 in FIG. 4. The IoT device may also be a UE, and the carrier signal may also be an excitation source signal.

In the IoT device 740, the impedance network selection control module 7404 selects an impedance network based on a second coded bit sequence output by the data encoding processing module 7406. Multiple circuit tuning frequencies are realized by adjusting the capacitance of the impedance network, such that the frequency of the sent signal varies with the circuit capacitance value, thereby realizing signal modulation such as frequency shift keying. In an embodiment, the IoT device includes t impedance networks 7402, and an impedance network is selected according to the second coded bit sequence. Any two of the t impedance networks have different network parameters. The parameter of the impedance network may include at least one of: a resistance value, a capacitance value, or an inductance value.

In an embodiment, the IoT device includes two impedance networks, which have different parameters, and selection of an impedance network is controlled by one bit in the second coded bit sequence. For example, when the bit is '0', an impedance network 0 is selected; when the bit is '1', an impedance network 1 is selected. In another example, the IoT device includes four impedance networks, which have different parameters, and selection of an impedance network is controlled by two bits in the second coded bit sequence. For example, when the two bits are '00', an impedance network 0 is selected; when the two bits are '01', an impedance network 1 is selected; when the two bits are '10', an impedance network 2 is selected; and when the two bits are '11', an impedance network 3 is selected. By analogy, more bits may be used for control, which will not be described in detail herein.

In an embodiment, the number of impedance networks 7402 is equal to 2 to the power of a, where a is a positive integer. That is to say, the impedance network selection control module 7404 selects an impedance network according to a state of a bits in the second coded bit sequence, where a is equal to at least one of 1, 2, 3, 4, or 5. a or the number t of target impedance networks is determined by at least one of: the length of the information bit sequence, the target length n, the preset target number q of times, higher-layer control signaling, etc. Because there are a plurality of impedance networks for selection, interference between signals sent by various IoT devices can be reduced. For example, in a large-scale IoT, it may be necessary to acquire information of a large number of IoT devices at a time, and different IoT devices may select different impedance networks to send data. If there are a large number of impedance networks available for use, those having ordinary skills in the art can use a selection control policy to reduce interference between signals sent by different IoT devices.

In an embodiment, the target length of the output of the convolutional coding 420 in FIG. 6 or the convolutional coding 520 in FIG. 7 is n, i.e., the number of component codes in the convolutional coding is n. The specific value of n is configured through higher-layer signaling. After the number n of component codes is determined, the specific value of the predetermined target number q of times the repeated expansion operation 440 is performed in FIG. 6 or the repeated expansion operation 540 is performed in FIG. 7 is further determined based on the number n of component codes.

In an embodiment, the target length n of the output of the convolutional coding 420 in FIG. 6 or the convolutional coding 520 in FIG. 7 is determined by the length of the information bit sequence. For example, the number n1 of component codes corresponding to the length K1 of the information bit sequence and the number n2 of component codes corresponding to the length K2 of the information bit sequence satisfy at least one of the following conditions: 1. if K1 is greater than K2, n1 is not less than n2; or 2. if K1 is greater than K2, n1 is not greater than n2.

In an embodiment, the predetermined target number q of times the repeated expansion operation 440 is performed in FIG. 6 or the repeated expansion operation 540 is performed in FIG. 7 is determined by the length K of the information bit sequence. The second coded bit sequence obtained in FIG. 6 or FIG. 7 is sent through the impedance networks in FIG. 10. The number of impedance networks is determined based on at least one of the following parameters: the target length, the number n of component codes in the convolutional coding, the preset target number q of times, and the length K of the information bit sequence. Alternatively, the number of impedance networks may be configured through higher-layer configuration signaling.

In an embodiment, when a plurality of target impedance networks are determined, any two of the target impedance networks have different network parameters. This can ensure that different target impedance networks have different characteristics, and makes it possible to use the target impedance networks in combination in specific application scenarios, so as to adapt to different and complex scenarios.

Example Three

Some specific examples are given below to illustrate specific procedures of determining some related parameters in the data processing method, e.g., the preset target number q of times, the target length n, etc.

The coding complexity and decoding complexity of the convolutional coding are directly related to the number n of component codes (i.e., the target length n), and the specific value of n may be determined according to the preset target number q of times. For example, an IoT communication system includes different UEs, and each UE can support different preset target numbers q of times. When the total number of bits to be sent is Y, and the preset target number q of times is configured by the system or through higher-layer signaling, the number n of component codes may be determined according to the preset target number q of times, the information bit sequence length K, and the total number Y of bits to be sent. In an embodiment, the number n of component codes is calculated according to the following formula:

$$n = function\left(Y/(q \cdot K)\right);$$

where function(x) represents a smallest integer greater than or equal to a real number x, an integer obtained by rounding the real number x, or a largest integer less than or equal to the real number x. The total number Y of bits may be the length of the second coded bit sequence. When the length K of the information bit sequence is an integer greater than 1 and less than or equal to 512, the length K of the information bit sequence is equal to an integer multiple of 8 from 24 to 512. The length K of the information bit sequence is equal to at least one of: 24, 64, 96, 128, 192, 256, 288, 384, or 512. The number n of component codes may be determined according to the length K of the information bit sequence. Such configuration is advantageous in that when the total number Y of bits to be sent is fixed, a more reasonable value of the number n of component codes can be used, thereby reducing the power consumption of encoding or decoding. It can be understood that when the number n of component codes determined above is greater than the number of generator polynomials in the convolutional coding, the number n of component codes may be equal to the number of generator polynomials in the convolutional coding, i.e., the generator polynomials in the convolutional coding and the number of generator polynomials may be uniformly predefined.

In an embodiment, the specific value of the number n of component codes is determined according to the preset target number q of times. For example, the preset target number of times has a value selected from 4, 8, 16, and 24. The preset target number of times is configured through higher-layer signaling. After acquiring the preset target number q of times, the IoT device determines the number n of component codes according to Table 3 below.

Table 3 Mapping table between the number n of component codes and the preset target number q of times

| q | 4 | 8 | 16 | 24 |
|---|----|----|----|----|
| n | 12 | 6 | 3 | 2 |

In an embodiment, a combination of the preset target number q of times and the number n of component codes may be indicated directly through signaling, e.g., a 2-bit signaling. Such configuration has the advantage of reducing signaling overheads. Because signaling generally occupies a large number of resources in communication, compressing the signaling can enhance the robustness of the communication system.

Example Four

In an embodiment, the specific value of the preset target number q of times is determined according to the number n of component codes. For example, when the total number of bits to be sent is Y and the number n of component codes is configured by an external system or through higher-layer signaling, the preset target number q of times may be determined based on the number n of component codes, the length K of the information bit sequence, and the total number Y of bits to be sent. For example, the number n of component codes is calculated according to the following formula:

$$q = function\left(Y/(n \cdot K)\right);$$

where function(x) represents a smallest integer greater than or equal to a real number x, an integer obtained by rounding the real number x, or a largest integer less than or equal to the real number x. The length K of the information bit sequence and the total number Y of bits to be sent may be configured by an external system or through higher-layer signaling.

In an embodiment, the specific value of the preset target number q of times is determined according to the number n of component codes. For example, the number of component codes has a value selected from 4, 7, 9, and 11. The number of component codes is configured through higher-layer signaling. After acquiring the specific value of n, the IoT device determines the preset target number q of times according to Table 4 below.

Table 4 Another mapping table between the number n of component codes and the number q of times of repeated expansion

| n | 4 | 7 | 9 | 11 |
|---|----|----|----|----|
| q | 32 | 20 | 10 | 5 |

In an embodiment, a combination of the number n of component codes and the preset target number q of times may be indicated directly through signaling, e.g., a 2-bit signaling. The signaling may be Radio Resource Control (RRC) signaling, Media Access Control (MAC) signaling, Downlink Control Information (DCI) signaling, etc.

Example Five

In the communication system shown in FIG. 10, the IoT Device 740 sends a signal 730 to the base station 710. An information bit sequence having a transmission length of K bits needs to be transmitted. The length of the information bit sequence may also be referred to as a transport block size. When there are only two impedance networks for selection, i.e., t=2, the zeroth impedance network is selected if a current bit of the second coded bit sequence is '0', and the first impedance network is selected if the current bit is '1'. In an example, the number of component codes in the convolutional coding in the data encoding processing module is 7, the preset target number of times is 6, and a second coded bit sequence with a total number of bits being Y needs to be transmitted. The impedance network selection control module 7404 controls selection of a corresponding impedance network according to the second coded bit sequence and sends the signal 730 to the base station 710 through backscattering.

FIG. 11 is a schematic diagram showing a comparison of performance of the second coded bit sequence corresponding to different preset numbers of times when the length of the information bit sequence is K=64 and the length of the second coded bit sequence is Y=3648. In FIG. 11, the abscissa represents a signal-to-noise ratio SNR of Additive White Gaussian Noise (AWGN), and the ordinate represents a Block Error Rate (BLER). The closer to the left of the BLER curve, the better the performance. The five BLER curves shown in FIG. 11 respectively correspond to values of the preset target number of times (Rep) being 5, 6, 8, 12, and 16. It can be found that when the preset target number of times is 6, the second coded bit sequence can obtain satisfactory performance.

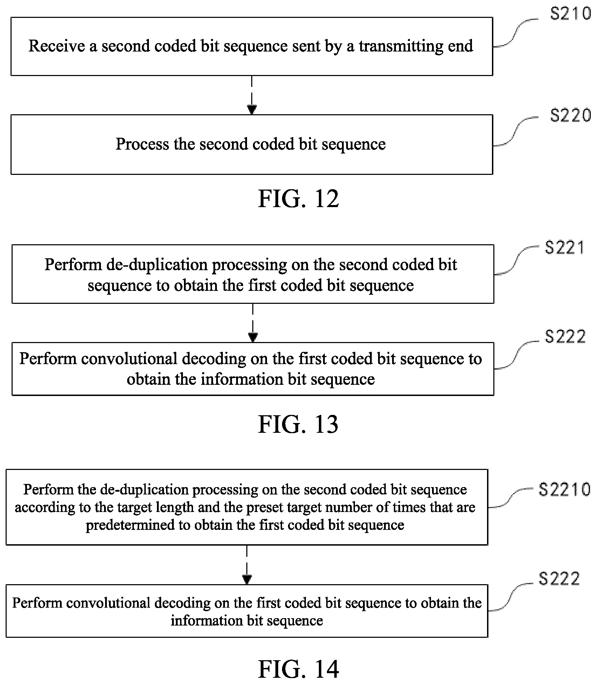

FIG. 12 is a flowchart of a data processing method according to another embodiment of the present disclosure. The data processing method may include, but not limited to, the following steps S210 to S220.

At S210, a second coded bit sequence sent by a transmitting end is received.

At S220, the second coded bit sequence is processed.

The second coded bit sequence is obtained by the transmitting end by performing a first operation or a second operation on a first coded bit sequence having a target length, and the first coded bit sequence is obtained by the transmitting end by performing error correction coding on an acquired information bit sequence.

The first operation includes: for each first bit in the first coded bit sequence, repeatedly generating another first bit until a preset target number of times is reached, to obtain a bit sequence including a plurality of first bits, and generating the second coded bit sequence sequentially according to the bit sequences.

The second operation includes: repeatedly generating another first coded bit sequence having the target length until a preset target number of times is reached, to obtain a plurality of first coded bit sequences, and generating the second coded bit sequence sequentially according to the plurality of first coded bit sequences.

In an embodiment, the execution entity of the data processing method in this embodiment may be, but not limited to, the receiving end 200 in the embodiment shown in FIG. 1 or the base station 210 in the embodiment shown in FIG. 2, or those having ordinary skills in the art may set the corresponding execution entity according to actual application scenarios, which is not limited in this embodiment. To more conveniently describe the application scenarios and principles of the present disclosure, the following related embodiments are described with the receiving end as the execution entity of the data processing method, which should not be construed as a limitation to the embodiments of the present disclosure.

In this step, the transmitting end performs error correction coding on an acquired information bit sequence to obtain a first coded bit sequence, repeatedly expands the obtained first coded bit sequence to obtain a second coded bit sequence, and sends the second coded bit sequence to a receiving end serving as a tap device. That is to say, the required second coded bit sequence can be obtained by repeatedly expanding each bit in the first coded bit sequence having a target length or the entire first coded bit sequence for a preset target number of times, the receiving end can easily and conveniently receive and process the second coded bit sequence. The entire processing process is simple and convenient to implement and does not have high hardware requirements. That is to say, the simplified implementation and data transmission reliability of the tap device can be ensured. In addition, the power consumption can be reduced. Therefore, the present disclosure can fill in the technical gap in related methods.

As shown in FIG. 13, in an embodiment of the present disclosure, S220 is further described, and S220 may include, but not limited to, the following steps S221 to S222.

At S221, de-duplication processing is performed on the second coded bit sequence to obtain the first coded bit sequence.

At S222, convolutional decoding is performed on the first coded bit sequence to obtain the information bit sequence.

In this step, de-duplication processing and convolutional decoding are sequentially performed on the received second coded bit sequence, such that the initial information bit sequence can be restored from the second coded bit sequence. Therefore, the source and content of the information bit sequence can be learned, and the performance of the second coded bit sequence and the information bit sequence can be more accurately and reliably obtained.

As shown in FIG. 14, in an embodiment of the present disclosure, S221 is further described, and S221 may include, but not limited to, a following step S2210.

At S2210, the de-duplication processing is performed on the second coded bit sequence according to the target length and the preset target number of times that are predetermined to obtain the first coded bit sequence.

In this step, the target length and the preset target number of times are predetermined, such that the de-duplication processing can be performed on the second coded bit sequence based on the target length and the preset target number of times to obtain the first coded bit sequence. That is to say, the intermediate first coded bit sequence may be further obtained through the above restoration operation.

In an embodiment of the present disclosure, S221 is further described, and S221 may include, but not limited to, at least one of:

when the second coded bit sequence includes a plurality of bit sequences each including a plurality of first bits, extracting the plurality of first bits from each bit sequence in the second coded bit sequence, and generating the first coded bit sequence sequentially according to the plurality of first bits; or

when the second coded bit sequence includes a plurality of first coded bit sequences, performing splitting and merging processing on the second coded bit sequence to obtain the first coded bit sequences.

In this step, in one method, the first coded bit sequence is obtained by performing extraction and merging processing on bit sequences in the second coded bit sequence, such that the bit sequences in the second coded bit sequence can be well associated, and the obtained first coded bit sequence can well reflect its characteristics. In another method, the first coded bit sequence is obtained by performing splitting and merging processing on the second coded bit sequence, such that the first coded bit sequences in the second coded bit sequence can be well associated, and the obtained first coded bit sequences can well reflect their characteristics.

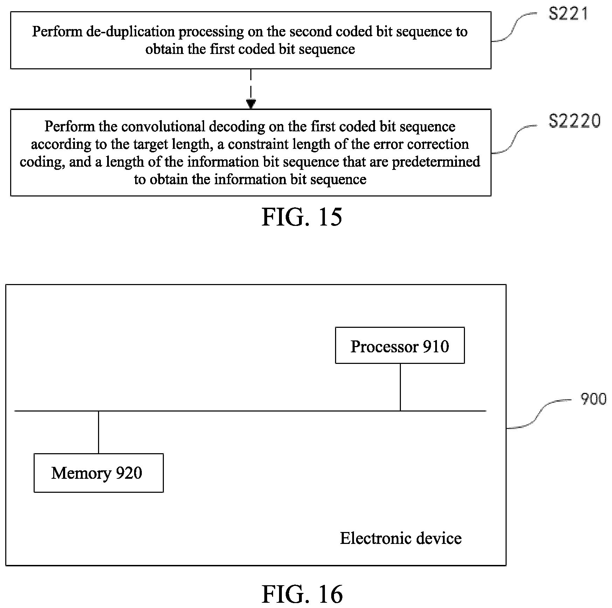

As shown in FIG. 15, in an embodiment of the present disclosure, S222 is further described, and S222 may include, but not limited to, a following step S2220.

At S2220, the convolutional decoding is performed on the first coded bit sequence according to the target length, a constraint length of the error correction coding, and a length of the information bit sequence that are predetermined to obtain the information bit sequence.

In this step, the length of the first coded bit sequence, the constraint length of the convolutional coding, and the length of the information bit sequence are predetermined, such that the convolutional decoding can be performed on the first coded bit sequence based on the length of the first coded bit sequence, the constraint length of the convolutional coding and the length of the information bit sequence, to obtain the information bit sequence. That is to say, the initial information bit sequence may be further obtained through the above restoration operation.

In an embodiment of the present disclosure, S210 is further described, and S210 may include, but not limited to, a following step S211.

At S211, the second coded bit sequence sent by the transmitting end is received according to a predetermined number of target impedance networks.

In this step, the number of related target impedance networks is predetermined, such that the second coded bit sequence sent by the transmitting end can be received based on the number of target impedance networks. Through the above restoration operation, the second coded bit sequence sent by the transmitting end can be received stably and reliably. For example, when there are a plurality of target impedance networks, any two of the target impedance networks have different network parameters. In this case, a desired target impedance network can be selected from the plurality of target impedance networks.

In an embodiment, the manner in which each parameter is predetermined in the above embodiments is not limited. For example, each parameter may be determined by an external operating system by controlling transmission or may be determined through higher-layer signaling, or the predetermining manner may be set according to an actual application scenario, which is not limited herein.

In an embodiment, the target length is determined by at least one of:

the preset target number of times;

a predetermined number of target impedance networks;

a constraint length of the error correction coding;

a length of the information bit sequence; or

high-layer configuration signaling.

In an embodiment, the preset target number of times is determined by at least one of:

the target length;

a predetermined number of target impedance networks;

a constraint length of the error correction coding;

a length of the information bit sequence; or

high-layer configuration signaling.

In an embodiment, a number of target impedance networks is determined by at least one of:

the target length;

the preset target number of times;

a constraint length of the error correction coding;

a length of the information bit sequence; or

high-layer configuration signaling.

In an embodiment, the error correction coding includes at least one of:

LDPC coding;

polar coding;

RS coding;

tail-biting convolutional coding; or

turbo coding.

In an implementation, the target length includes at least one of: 2, 3, 4, 5, 6, 7, 8, 9, 10, 11, or 12.
In an implementation, the preset target number of times includes at least one of: 4, 5, 6, 7, 8, 12, 16, 24, 32, 48, or 64.
In an implementation, when the error correction coding includes convolutional coding, a constraint length of the convolutional coding includes at least one of: 7, 8, 9, 10, or 11.
In an implementation, the number of target impedance networks includes at least one of: 2, 4, 8, 16, or 32.
In an embodiment, because the target length, the preset target number of times, the number of target impedance networks, the type of error correction coding, and the like have been described in detail in the above embodiments, and the difference between the above embodiments and this embodiment lies only in the execution entity, i.e., the above embodiments are executed by the transmitting end and this embodiment is executed by the receiving end, related implementation in this embodiment correspond to those in the above embodiments. To avoid redundancy, the target length, the preset target number of times, the number of target impedance networks, the type of error correction coding, and the like will not be described in detail again.
In addition, as shown in FIG. 16, an embodiment of the present disclosure discloses an electronic device 900, including: at least one processor 910; and at least one memory 920, configured for storing at least one program, where the at least one program, when executed by the at least one processor 910, causes the at least one processor 910 to perform the data processing method according to any one of the above embodiments.
In addition, an embodiment of the present disclosure provides a computer-readable storage medium, storing a computer-executable instruction which, when executed by a processor, causes the processor to perform the data processing method according to any one of the above embodiments.

In addition, an embodiment of the present disclosure provides a computer program product, including a computer-readable storage medium storing a computer program or computer instructions which, when read and executed by a processor of a computer device, causes the computer device to perform the data processing method according to any one of the above embodiments.

Those having ordinary skills in the art can understand that all or some of the steps in the methods disclosed above and the functional modules/units in the system and the apparatus can be implemented as software, firmware, hardware, and appropriate combinations thereof. Some or all physical components may be implemented as software executed by a processor, such as a central processing unit, a digital signal processor, or a microprocessor, or as hardware, or as an integrated circuit, such as an application-specific integrated circuit. Such software may be distributed on a computer-readable medium, which may include a computer storage medium (or non-transitory medium) and a communication medium (or transitory medium). As is known to those having ordinary skills in the art, the term "computer storage medium" includes volatile and nonvolatile, removable and non-removable media implemented in any method or technology for storage of information (such as computer-readable instructions, data structures, program modules, or other data). The computer storage medium includes, but not limited to, a Random Access Memory (RAM), a Read-Only Memory (ROM), an Electrically Erasable Programmable Read-Only Memory (EEPROM), a flash memory or other memory technology, a Compact Disc Read-Only Memory (CD-ROM), a Digital Versatile Disc (DVD) or other optical storage, a cassette, a magnetic tape, a magnetic disk storage or other magnetic storage device, or any other medium which can be used to store the desired information and which can be accessed by a computer. In addition, as is known to those having ordinary skill in the art, the communication medium typically includes computer-readable instructions, data structures, program modules, or other data in a modulated data signal such as a carrier or other transport mechanism, and can include any information delivery medium.

**Claims**

1. A data processing method, comprising:

    performing error correction coding on an acquired information bit sequence to obtain a first coded bit sequence having a target length;
    repeatedly expanding the first coded bit sequence to obtain a second coded bit sequence; and
    sending the second coded bit sequence to a receiving end,
    wherein repeatedly expanding the first coded bit sequence to obtain a second coded bit sequence comprises:

       for each first bit in the first coded bit sequence, repeatedly generating another first bit until a preset target number of times is reached, to obtain a bit sequence comprising a plurality of first bits, and generating the second coded bit sequence sequentially according to the respective bit sequences; or
       repeatedly generating another first coded bit sequence having the target length until a preset target number of times is reached, to obtain a plurality of the first coded bit sequences, and generating the second coded bit sequence sequentially according to the plurality of the first coded bit sequences.

2. The data processing method of claim 1, wherein performing error correction coding on an acquired information bit sequence to obtain a first coded bit sequence having a target length comprises:
   performing convolutional coding on each second bit in the acquired information bit sequence to obtain the first coded bit sequence having the target length.

3. The data processing method of claim 1, wherein sending the second coded bit sequence to a receiving end comprises:

    determining a target impedance network according to the second coded bit sequence; and
    sending the second coded bit sequence to the receiving end through the target impedance network.

4. The data processing method of claim 1, wherein the target length is determined by at least one of:

    the preset target number of times;
    a predetermined number of target impedance networks;
    a constraint length of the error correction coding;
    a length of the information bit sequence; or
    high-layer configuration signaling.

**5.** The data processing method of claim 1, wherein the preset target number of times is determined by at least one of:

the target length;
a predetermined number of target impedance networks;
a constraint length of the error correction coding;
a length of the information bit sequence; or
high-layer configuration signaling.

**6.** The data processing method of claim 3, wherein a number of target impedance networks is determined by at least one of:

the target length;
the preset target number of times;
a constraint length of the error correction coding;
a length of the information bit sequence; or
high-layer configuration signaling.

**7.** The data processing method of claim 1, wherein the error correction coding comprises at least one of:

Low Density Parity Check (LDPC) coding;
polar coding;
Reed-Solomon (RS) coding;
tail-biting convolutional coding; or
turbo coding.

**8.** The data processing method of claim 1, wherein the target length comprises at least one of: 2, 3, 4, 5, 6, 7, 8, 9, 10, 11, or 12.

**9.** The data processing method of claim 1, wherein the preset target number of times comprises at least one of: 4, 5, 6, 7, 8, 12, 16, 24, 32, 48, or 64.

**10.** The data processing method of claim 2, wherein a constraint length of the convolutional coding comprises at least one of: 7, 8, 9, 10, or 11.

**11.** The data processing method of claim 3, wherein the number of target impedance networks comprises at least one of: 2, 4, 8, 16, or 32.

**12.** The data processing method of claim 3, wherein in response to existence of a plurality of target impedance networks, any two of the target impedance networks have different network parameters.

**13.** A data processing method, comprising:

receiving a second coded bit sequence sent by a transmitting end; and
processing the second coded bit sequence,
wherein the second coded bit sequence is obtained by the transmitting end by performing a first operation or a second operation on a first coded bit sequence having a target length, and the first coded bit sequence is obtained by the transmitting end by performing error correction coding on an acquired information bit sequence;
the first operation comprises: for each first bit in the first coded bit sequence, repeatedly generating another first bit until a preset target number of times is reached, to obtain a bit sequence comprising a plurality of first bits, and generating the second coded bit sequence sequentially according to the respective bit sequences; and
the second operation comprises: repeatedly generating another first coded bit sequence having the target length until a preset target number of times is reached, to obtain a plurality of first coded bit sequences, and generating the second coded bit sequence sequentially according to the plurality of first coded bit sequences.

**14.** The data processing method of claim 13, wherein processing the second coded bit sequence comprises:

performing de-duplication processing on the second coded bit sequence to obtain the first coded bit sequence; and

performing convolutional decoding on the first coded bit sequence to obtain the information bit sequence.

15. The data processing method of claim 14, wherein performing de-duplication processing on the second coded bit sequence to obtain the first coded bit sequence comprises:
performing the de-duplication processing on the second coded bit sequence according to the target length and the preset target number of times that are predetermined to obtain the first coded bit sequence.

16. The data processing method of claim 14, wherein performing convolutional decoding on the first coded bit sequence to obtain the information bit sequence comprises:
performing the convolutional decoding on the first coded bit sequence according to the target length, a constraint length of the error correction coding, and a length of the information bit sequence that are predetermined to obtain the information bit sequence.

17. The data processing method of claim 14, wherein performing de-duplication processing on the second coded bit sequence to obtain the first coded bit sequence comprises at least one of:

in response to the second coded bit sequence comprising a plurality of bit sequences each comprising a plurality of first bits, extracting the plurality of first bits from each bit sequence in the second coded bit sequence, and generating the first coded bit sequence sequentially according to the plurality of first bits; or
in response to the second coded bit sequence comprising a plurality of first coded bit sequences, performing splitting and merging processing on the second coded bit sequence to obtain the first coded bit sequences.

18. The data processing method of claim 13, wherein receiving a second coded bit sequence sent by a transmitting end comprises:
receiving, according to a predetermined number of target impedance networks, the second coded bit sequence sent by the transmitting end.

19. The data processing method of claim 13, wherein the target length is determined by at least one of:

the preset target number of times;
a predetermined number of target impedance networks;
a constraint length of the error correction coding;
a length of the information bit sequence; or
high-layer configuration signaling.

20. The data processing method of claim 13, wherein the preset target number of times is determined by at least one of:

the target length;
a predetermined number of target impedance networks;
a constraint length of the error correction coding;
a length of the information bit sequence; or
high-layer configuration signaling.

21. The data processing method of claim 18, wherein a number of target impedance networks is determined by at least one of:

the target length;
the preset target number of times;
a constraint length of the error correction coding;
a length of the information bit sequence; or
high-layer configuration signaling.

22. The data processing method of claim 13, wherein the error correction coding comprises at least one of:

Low Density Parity Check (LDPC) coding;
polar coding;
Reed-Solomon (RS) coding;
tail-biting convolutional coding; or

turbo coding.

23. The data processing method of claim 13, wherein the target length comprises at least one of: 2, 3, 4, 5, 6, 7, 8, 9, 10, 11, or 12.

24. The data processing method of claim 13, wherein the preset target number of times comprises at least one of: 4, 5, 6, 7, 8, 12, 16, 24, 32, 48, or 64.

25. The data processing method of claim 13, wherein in response to the error correction coding comprising convolutional coding, a constraint length of the convolutional coding comprises at least one of: 7, 8, 9, 10, or 11.

26. The data processing method of claim 18, wherein the number of target impedance networks comprises at least one of: 2, 4, 8, 16, or 32.

27. The data processing method of claim 18, wherein in response to existence of a plurality of target impedance networks, any two of the target impedance networks have different network parameters.

28. An electronic device, comprising:

    at least one processor; and
    at least one memory, configured for storing at least one program,
    wherein the at least one program, when executed by the at least one processor, causes the at least one processor to perform the data processing method of any of claims 1 to 27.

29. A computer-readable storage medium, storing a processor-executable program which, when executed by a processor, causes the processor to perform the data processing method of any of claims 1 to 27.

30. A computer program product, comprising computer-readable storage medium storing a computer program or computer instructions which, when read and executed by a processor of a computer device, causes the computer device to perform the data processing method of any of claims 1 to 27.

Second coded bit sequence

100    200

FIG. 1

210

120    140

Core network

130    300

FIG. 2

800

Data encoding processing module

810

Transmitter

820

FIG. 3

Perform error correction coding on an acquired information bit sequence to obtain a first coded bit sequence having a target length — S110

Repeatedly expand the first coded bit sequence to obtain a second coded bit sequence — S120

Send the second coded bit sequence to a receiving end — S130

FIG. 4

Perform convolutional coding on each second bit in the acquired information bit sequence to obtain the first coded bit sequence having the target length — S1101

Repeatedly expand the first coded bit sequence to obtain a second coded bit sequence — S120

Send the second coded bit sequence to a receiving end — S130

FIG. 5

FIG. 6

FIG. 7

Input a $k^{th}$ bit

610

c0 — 620
c1
c2
c3
c4
c5
c6
c7
c8
c9
c10
c11

First coded bit sequence

## FIG. 8

| Determine a target impedance network according to the second coded bit sequence | S1301 |

| Send the second coded bit sequence to the receiving end through the target impedance network | S1302 |

## FIG. 9

FIG. 10

FIG. 11

Receive a second coded bit sequence sent by a transmitting end ⟋ S210

Process the second coded bit sequence ⟋ S220

## FIG. 12

Perform de-duplication processing on the second coded bit sequence to obtain the first coded bit sequence ⟋ S221

Perform convolutional decoding on the first coded bit sequence to obtain the information bit sequence ⟋ S222

## FIG. 13

Perform the de-duplication processing on the second coded bit sequence according to the target length and the preset target number of times that are predetermined to obtain the first coded bit sequence ⟋ S2210

Perform convolutional decoding on the first coded bit sequence to obtain the information bit sequence ⟋ S222

## FIG. 14

Perform de-duplication processing on the second coded bit sequence to obtain the first coded bit sequence — S221

Perform the convolutional decoding on the first coded bit sequence according to the target length, a constraint length of the error correction coding, and a length of the information bit sequence that are predetermined to obtain the information bit sequence — S2220

FIG. 15

Processor 910

900

Memory 920

Electronic device

FIG. 16

<table>
<tr><td colspan="2" align="center">**INTERNATIONAL SEARCH REPORT**</td><td>International application No.<br>**PCT/CN2023/089282**</td></tr>
</table>

**A. CLASSIFICATION OF SUBJECT MATTER**

H03M13/03(2006.01)i

According to International Patent Classification (IPC) or to both national classification and IPC

**B. FIELDS SEARCHED**

Minimum documentation searched (classification system followed by classification symbols)

H03M

Documentation searched other than minimum documentation to the extent that such documents are included in the fields searched

Electronic data base consulted during the international search (name of data base and, where practicable, search terms used)

CNTXT; ENTXT; ENTXTC; WPABS; CJFD: 数据处理, 编码, 比特, 第一编码, 第二编码, 重复, 复用, 扩展, 次数, 序列, 接收, 发送, coding, data, the first code, the second code, expansion, number, receive, transmit

**C. DOCUMENTS CONSIDERED TO BE RELEVANT**

| Category* | Citation of document, with indication, where appropriate, of the relevant passages | Relevant to claim No. |
|---|---|---|
| A | CN 114430278 A (HUAWEI TECHNOLOGIES CO., LTD.) 03 May 2022 (2022-05-03)<br>description, paragraphs 75-176, and figures 1-15 | 1-30 |
| A | CN 101399582 A (DATANG MOBILE COMMUNICATIONS EQUIPMENT CO., LTD.) 01 April 2009 (2009-04-01)<br>entire document | 1-30 |
| A | CN 108111256 A (THE 7TH RESEARCH INSTITUTE OF CHINA ELECTRONICS TECHNOLOGY GROUP CORP.) 01 June 2018 (2018-06-01)<br>entire document | 1-30 |
| A | CN 110166167 A (HUAWEI TECHNOLOGIES CO., LTD.) 23 August 2019 (2019-08-23)<br>entire document | 1-30 |
| A | US 7609000 B1 (GOOGLE INC.) 27 October 2009 (2009-10-27)<br>entire document | 1-30 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **16 June 2023** | **23 June 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/089282**

| Patent document cited in search report | | | Publication date (day/month/year) | Patent family member(s) | | | Publication date (day/month/year) |
|---|---|---|---|---|---|---|---|
| CN | 114430278 | A | 03 May 2022 | WO | 2022088709 | A1 | 05 May 2022 |
| CN | 101399582 | A | 01 April 2009 | CN | 101399582 | B | 21 November 2012 |
| CN | 108111256 | A | 01 June 2018 | CN | 108111256 | B | 02 November 2021 |
| CN | 110166167 | A | 23 August 2019 | WO | 2019158031 | A1 | 22 August 2019 |
| | | | | CN | 110166167 | B | 10 May 2022 |
| US | 7609000 | B1 | 27 October 2009 | | None | | |

Form PCT/ISA/210 (patent family annex) (July 2022)

**EP 4 510 457 A1**

**Patent documents cited in the description**

- CN 202210545672